# EUROPÄISCHE PATENTSCHRIFT

(11) **EP 2 845 456 B1**
(45) Veröffentlichungstag und Bekanntmachung des Hinweises auf die Patenterteilung: **15.11.2017**
(21) Anmeldenummer: 13720315.4
(22) Anmeldetag: 24.04.2013
(51) Int. Cl.: H05K 3/32, H05K 3/34

(54) **ELEKTRISCHE DURCHKONTAKTIERUNG MIT MECHANISCHER DÄMPFUNG**
ELECTRICAL VIA HAVING MECHANICAL DAMPING
LIAISON ÉLECTRIQUE PAR TROU MÉTALLISÉ AVEC AMORTISSEMENT MÉCANIQUE

(30) Priorität: 02.05.2012 DE 102012207296
(43) Veröffentlichungstag der Anmeldung: 11.03.2015
(73) Patentinhaber: Robert Bosch GmbH, 70442 Stuttgart (DE)
(72) Erfinder: GUYENOT, Michael, 71638 Ludwigsburg (DE); RATCHEV, Roumen, 70499 Stuttgart (DE); FIX, Andreas, 70439 Stuttgart (DE)
(86) Internationale Anmeldenummer: PCT/EP2013/058470
(87) Internationale Veröffentlichungsnummer: WO 2013/164230

(56) Entgegenhaltungen:
- DE-C1- 19 853 153
- JP-A- H06 168 845
- JP-A- 2000 138 131

## Beschreibung

### Stand der Technik

DE 10 2004 030 388 A1 bezieht sich auf einen Artikel mit einer Beschichtung von elektrisch leitfähigem Polymer und ein Verfahren zu dessen Herstellung. Gemäß dieser Lösung sind Leiterplatten mit einer Kupferschicht versehen, in welcher durch Strukturierung elektrische Leiter erzeugt werden. Zur Erhaltung der Lötfähigkeit und zum Schutz vor Oxidation wird eine Schicht aus einem elektrisch leitfähigen Polymer auf die Kupferschicht aufgetragen. Die Kupfer- oder Kupferlegierungsschicht befindet sich zwischen einer elektrisch leitend ausgebildeten Basisschicht und einer das leitfähige Polymer enthaltenden Schicht.

DE 10 2009 001 461 A1 bezieht sich auf ein Verfahren zur Herstellung einer elektronischen Baugruppe. Die Baugruppe wird durch zwei mikroelektronische Bauelemente gebildet, die miteinander verbunden werden. Die Herstellung der Verbindung erfolgt mittels mehrerer dielektrischer Bauelemente, die jeweils mindestens eine Leiterbahn aufweisen. Die Leiterbahn wird durch das Einbringen eines durchgängigen Hohlraumes in das dielektrische Bauelement und anschließendem Füllen mit einem elektrisch leitfähigen Material erzeugt. Bei dem Füllmaterial kann es sich um ein elektrisch leitfähiges Polymer handeln.

Aus der Patentschrift DE19853153C1 ist ein Verfahren zur Kontaktierung eine Bauelementes bekannt. Hierbei wird mindestens ein Kontaktelement des Bauelementes mittels einer schmelzflüssigen Lotlegierung mit einer auf einem Schaltungsträger vorgesehenen Kontaktfäche unter Bildung einer Lötstelle kontaktiert. Um einen elektrischen Kontakt selbst bei einem Bruch der Lötstelle zu gewährleisten, ist vorgesehene, dass die Lötstelle nach der Erstarrung der Lötlegierung mit einem leitfähigen Polymer überdeckt wird.

Zur elektrischen Kontaktierung wird das THT-Fertigungsverfahren (Through Hole Technology) eingesetzt. Gemäß diesem Fertigungsverfahren werden die Anschlussdrähte bedrahteter Bauteile und Messerleisten durch Öffnungen in der Leiterplatte gesteckt. Bei den zu kontaktierenden Bauelementen kann es sich Kondensatoren, Transistoren, Widerstände, integrierte Schaltkreise (Intergrated Circuits (ICs)) und dergleichen mehr handeln. Die aufgezählten Bauteile benötigen unterschiedliche Vorbereitungen, bei denen die Anschlussdrähte, die auch als Anschlussbeinchen bezeichnet werden, gebogen und zugeschnitten werden, so dass diese in ein durch die Leiterplatte vorgegebenes Bohrbild bzw. Öffnungsmuster passen. Nach der Vorbereitung der Bauteile und der Bestückung der Leiterplatte mit diesen, erfolgt das Löten der Bauteile. Die Lötverbindung entsteht in der Regel auf der Unterseite der Leiterplatte.
Hierfür steht das Wellenlötverfahren oder auch Schwalllötverfahren genannt zur Auswahl. Beim Wellenlöten wird die Leiterplatte mit ihrer Unterseite über eine Lotwelle gefahren, welche bei Kontakt mit dem Bauteil die Lötverbindung an dessen Unterseite herstellt. Eine Sonderausführung dieses Verfahrens ist das Selektivlöten. Hierbei wird nicht die ganze Baugruppe, sondern nur ein kleiner Teil davon - teilweise nur ein einziges Bauteil - mittels einer "Miniatur-Welle" gelötet. Das Selektivlötverfahren ist häufig das einzig mögliche Lötverfahren, wenn beidseitig bedrahtete Bauelemente gelötet werden müssen.

Bedingt durch den sich abzeichnenden Trend, Steuergeräte intramodular aufzubauen, werden Module, nicht nur einzelne Bauelemente, durch die THT-Technik mit der Leiterplatte elektrisch kontaktiert.

Insbesondere bei Anwendungen im Automobilbereich müssen die mittels des THT-Fertigungsverfahren hergestellten Lötstellen eine große Anzahl von Temperaturwechseln ertragen können, ohne dass die Funktion der Lötstelle, einerseits hinsichtlich der elektrischen Leitfähigkeit und andererseits hinsichtlich des mechanischen Haltes, signifikant beeinträchtigt wird. Durch die Temperaturwechsel entstehen in den Lötstellen jedoch thermomechanisch induzierte Belastungen, die zur Schädigung der Lötstellen führen können. Diese Belastungen sind sowohl durch Geometriefaktoren in Bezug auf alle Komponenten bestimmt und des Weiteren von transient thermischen Zuständen (Temperatur-Zeit-Profil) abhängig.

### Offenbarung der Erfindung

Erfindungsgemäß wird vorgeschlagen, bei der Herstellung von THT-Durchkontaktierungen zwischen elektrisch zu kontaktierenden Bauelementen bzw. Modulen und einer mit einem entsprechenden Bohrbild oder Öffnungsmuster versehenen Leiterplatte die Kontaktdrähte bzw. Kontaktbeinchen der elektrisch zu kontaktierenden Bauelemente im Bereich der Lötspitzen mit einer leitfähigen Polymerschicht teil- und/oder vollflächig zu versehen. Bei der eingesetzten leitfähigen Polymerschicht kann es sich zum Beispiel um eine hochgefüllte Leitklebeverbindung handeln. Die elektrisch leitfähige Polymerschicht wird teil- und/oder vollflächig auf die Lötspitzen der zu kontaktierenden Kontaktdrähte bzw. Kontaktbeinchen aufgebracht, so dass diese im nachfolgenden Selektivlötprozess, der einen Sonderfall des Wellenlötprozesses darstellt und die Lötung einzelner Pins auf komplexen Leiterplatten ermöglicht, in verkupfert ausgebildete Durchkontaktierungen eingelötet werden. In vorteilhafter Weise werden dadurch thermisch induzierte Belastungen, die durch die oben stehend angesprochenen Temperaturwechsel auftreten und in Form von Biegen, Drehen und Ziehen auf den Kontaktdraht bzw. das Kontaktbeinchen einwirken durch die flexible Polymerschicht abgefedert. Dadurch ergibt sich bei Anwendung der erfindungsgemäß vorgeschlagenen Lösung eine erheblich längere schadensfreie Zeitspanne der elektrischen Durchkontaktierung und damit eine höhere Lebensdauer der elektrischen Kontaktierung, deren Ausfallwahrscheinlichkeit durch die erfindungsgemäß vorgeschlagene Lösung signifikant reduziert ist.

### Vorteile der Erfindung

Durch die erfindungsgemäß vorgeschlagene Lösung kann erreicht werden, dass thermisch induzierte Belastungen, die auf die Kontaktbeinchen bzw. auf die Kontaktdrähte von elektrisch zu kontaktierenden Bauelementen einwirken, durch die leitfähige Polymerschicht abgefedert werden können. Diese fungiert als Dämpfungselement, welches die bei thermisch induzierten mechanischen Belastungen aufgrund von Biegung, Drehung oder Zugbelastung auftretende Kräfte erheblich herabsetzt. Dadurch lässt sich eine erheblich längere schadensfreie Zeit erreichen, so dass eine höhere Lebensdauer der elektrischen Durchkontaktierung zwischen der Leiterplatte und dem elektrischen bzw. elektronischen Bauelement erreicht wird. Bei den elektronischen Bauelementen kann es sich um Kondensatoren, Transistoren, Widerstände, Integrierte Schaltkreise (ICs) und dergleichen mehr handeln.

Ein weiterer Vorteil der erfindungsgemäß vorgeschlagenen Lösung ist darin zu erblicken, dass bei dieser Lösung größere Lötprozesstoleranzen bei gleichbleibender Lebensdauer zugelassen werden können. Geringe Lotdurchstiegshöhen führen zu einer Reduktion der Zuverlässigkeit, da die eingekoppelten Belastungen über den Pin, d.h. den Kontaktstift, zu einer früheren Schädigung der Lötstelle führen können. Durch die dämpfende Eigenschaft der leitfähigen Polymerschicht wird ein Teil der mechanischen Belastung abgefedert, was in Konsequenz zu einer größeren erlaubten Lötprozesstoleranz führt. Des Weiteren kann die erfindungsgemäß vorgeschlagene Lösung auf alle mittels der THT-Kontaktierungstechnik kontaktierbaren Bauteile wie beispielsweise Kondensatoren, Spulen, Widerstände, Steckerleisten und dergleichen ausgeweitet werden.

### Kurze Beschreibung der Zeichnungen

Anhand der Zeichnung wird die Erfindung nachstehend eingehender beschrieben.

Es zeigt:
- Figur 1: eine elektrisch zu kontaktierende Komponente, die sich oberhalb einer Leiterplatte befindet,
- Figur 2: zeigt das Erzeugen einer elektrischen Kontaktierung zwischen einer elektrischen Kontaktierungsschicht an der Unterseite der Leiterplatte und den diesen durchsetzenden Kontaktbeinchen bzw. Kontaktdrähten durch eine Lotwelle,
- Figur 3: ein elektronisches Bauelement, welches mit der Leiterplatte kontaktiert,
- Figur 4: den in Figur 3 dargestellten Bereich in vergrößerter Darstellung mit einer leitfähigen Polymerschicht und
- Figur 5: Lötspitzen von Kontaktdrähten bzw. Kontaktbeinen unterschiedlicher Länge, die jeweils mit einer elektrisch leitfähigen Polymerschicht versehen sind.

### Ausführungsvarianten

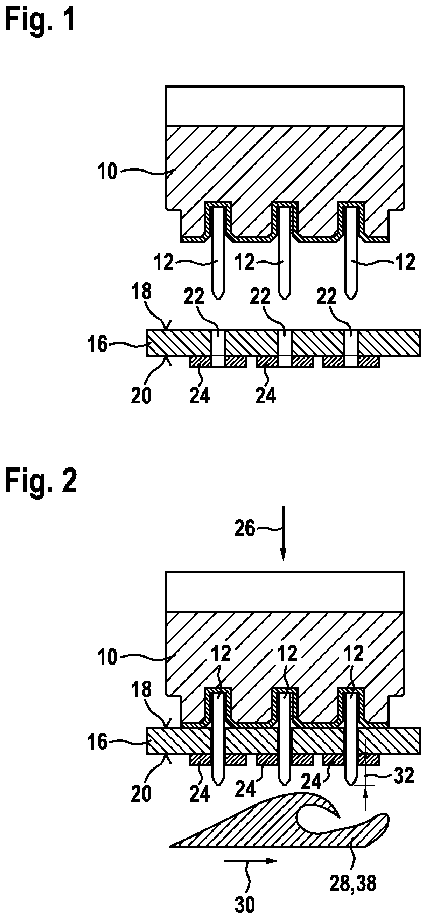

Figur 1 zeigt eine elektrisch zu kontaktierende Komponente, deren Kontaktdrähte mit einem Öffnungs- bzw. Lochmuster einer Leiterplatte gefügt werden.

Aus der Darstellung gemäß Figur 1 geht eine zu kontaktierende Komponente 10 hervor, bei der es sich um einen Kondensator, um einen Transistor, um einen Widerstand, um einen integrierten Schaltkreis (Integrated Circuit (IC)) oder einen Stecker handeln kann. Je nach Konfiguration der zu kontaktierenden Komponente sind unterschiedliche Vorbereitungsschritte erforderlich, bei denen die sich in der Darstellung gemäß Figur 1 an der Unterseite der zu kontaktierenden Komponente 10 befindlichen Kontaktdrähte 12 gebogen und gegebenenfalls hinsichtlich ihrer Länge zugeschnitten werden. Beim dem THT-Fertigungsverfahren (Through Hole Technology) ist eine Übereinstimmung des Bildes der Kontaktdrähte 12 an der Unterseite der zu kontaktierenden Komponente mit dem Öffnungs- bzw. Lochmuster auf der Oberseite der Leiterplatte erforderlich. Das Bild bzw. die Anordnung der Kontaktdrähte 12 an der Unterseite der zu kontaktierenden Komponente 10 muss außerdem zu dem auf der Leiterplatte 16 an deren Oberseite 18 ausgebildeten Bohrbild bzw. Lochbild, also der Anordnung der Öffnungen bzw. Bohrungen 22 passen. Aus der Schnittdarstellung gemäß Figur 1 geht hervor, dass sich an der Unterseite 20 der Leiterplatte 16 eine Kontaktierungsschicht 24, beispielsweise eine Kupferschicht befindet. Durch das THT-Verfahren, d.h. den Einsatz der Through Hole Technology, werden die entsprechend vorbereiteten Kontaktdrähte 12, die sich an der Unterseite der zu kontaktierenden Komponente 10 befinden, in das dem Kontaktdrahtbild aus Kontaktdrähten 12 entsprechende Bohrbild von Löchern 22 bzw. Öffnungen eingeführt.

Der gefügte Zustand zwischen der zu kontaktierenden Komponente und der Leiterplatte ist in Figur 2 gezeigt. Figur 2 zeigt eine Darstellung der miteinander gefügten Komponenten Leiterplatte und zu kontaktierende Komponente.

Wie aus Figur 2 hervorgeht, hat sich - bei unveränderter Position der Leiterplatte 16 - die zu kontaktierende Komponente 10 eine Absenkbewegung 26 ausführend, nach unten bewegt. Bei der Absenkbewegung 26 der zu kontaktierenden Komponente 10 haben die Kontaktdrähte 12, die von der Unterseite der zu kontaktierenden Komponente 10 hervorstehen, zugeordnete Löcher bzw. Bohrungen 22 der Leiterplatte 16 durchtreten und stehen auf der Unterseite 20 der Leiterplatte 16 mit der Kontaktierungsschicht 24 in Kontakt. Die Kontaktierungsschicht 24 ist an der Unterseite 20 der Leiterplatte 16 derart ausgeführt, dass die Löcher bzw. die Bohrungen 22 jeweils von der Kontaktierungsschicht 24 berandet sind, wobei hier in der Darstellung gemäß Figur 2 Verkupferungen 36, die an den Wänden der Löcher bzw. Öffnungen 22 der Leiterplatte 16 ausgeführt sind, nicht dargestellt sind.

Aus Figur 2 geht hervor, dass nach erfolgter Absenkbewegung 26 der zu kontaktierenden Komponente 10 die Enden der Kontaktdrähte 12 um einen Überstand 32 über die Unterseite der Kontaktierungsschicht 24 - in der Regel Kupfer - hervorstehen. Erfolgt nun - wie in Figur 2 angedeutet - der Aufbau einer Lotwelle 28 aus Lot 38 und deren Relativbewegung 30 entlang der Kontaktdrähte 12, die im Überstand 32 über die Unterseite der Kontaktierungsschicht 24 hervorstehen, wird eine Verlötung, d.h. eine elektrische Kontaktierung zwischen den Kontaktdrähten 12 und der Leiterplatte 16 im Bereich der Kontaktierungsschicht 24 geschaffen.

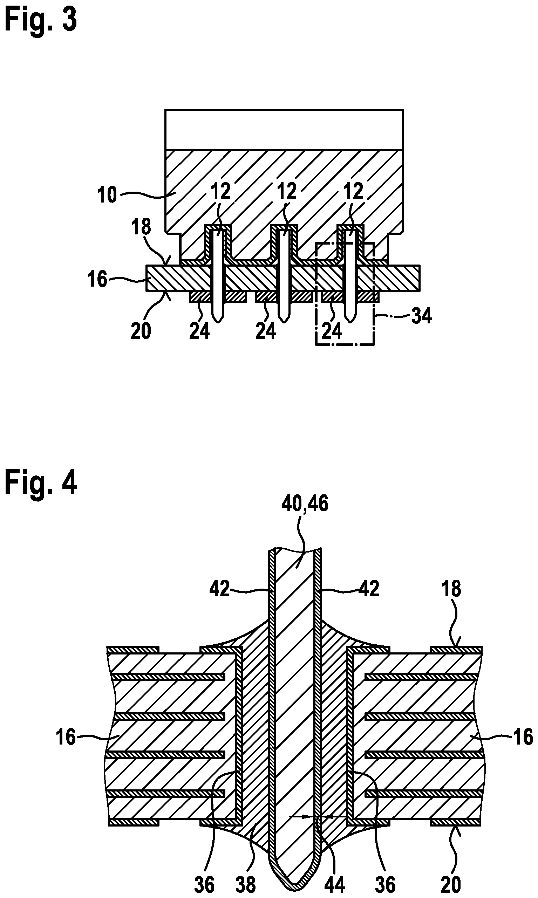

Figur 3 zeigt einen Anschlussdraht, der die Absenkbewegung 26 ausgeführt habenden, zu kontaktierenden Komponente 10, der sich durch eine zugehörige Öffnung bzw. ein Loch 22 von der Oberseite 18 zur Unterseite der Leiterplatte 16 erstreckt und an der Kontaktierungsschicht 24 gemäß der Darstellung in Figur 2 durch Lot 38, beispielsweise durch eine Vorbeibewegung der Lotwelle 28, elektrisch kontaktiert ist.

Ein vergrößerter Ausschnitt ist mit Bezugszeichen 34 bezeichnet, der in Figur 4 in vergrößertem Maßstab dargestellt ist.

Unter Verwendung der bewährten und gebräuchlichen THT-Befestigungstechnik (Through Hole Technology) werden mit dem erfindungsgemäß vorgeschlagenen Verfahren die Anschlussdrähte 12 der zu kontaktierenden Komponente 10 mit der Leiterplatte 16 gefügt. Dadurch entsteht eine elektrische Durchkontaktierung, welche sich durch sämtliche Ebenen eines beispielsweise als Schichtaufbau beschaffenen Leiterplattensubstrates erstrecken kann. Die elektrische Durchkontaktierung umfasst meist eine innenmetallisierte Bohrung oder Öffnung im Trägerplattensubstrat. Als elektrische Durchkontaktierungen werden solche Kontaktierungen verstanden, die sich zwischen der Ober- und der Unterseite eines Schaltungsträgers erstrecken und auf diesem Durchgang noch Stromabzweigungen haben können. Bei elektrischen Durchkontaktierungen kann es sich auch um solche handeln, die sich nicht durch die gesamte Leiterplatine, sondern nur bis zu einer der Mittellagen erstrecken, in diesem Falle spricht man von "blind via". Befinden sich die elektrischen Durchkontaktierungen "vergraben" nur zwischen Mittellagen, so werden diese als "buried via" bezeichnet. In der Darstellung gemäß Figur 4 ist eine elektrische Durchkontaktierung dargestellt, die durch das erfindungsgemäß vorgeschlagene Verfahren hergestellt wird, die sich durch die gesamte Leiterplatte 16, d.h. von deren Oberseite 18 bis zur Unterseite 20 erstreckt.

Erfindungsgemäß wird vorgeschlagen, insbesondere Lötspitzen 46 der Kontaktdrähte 12 der zu kontaktierenden Komponente 10 vorzubehandeln. Dazu werden die Kontaktdrähte 12 nach entsprechender Längung bzw. einem eventuell erforderlichen Vorbiegen mit einem leitfähigen Polymer versehen. Bei der leitfähigen Polymerschicht, angedeutet durch Bezugszeichen 42 in der Darstellung gemäß Figur 4, handelt es sich beispielsweise um eine hochgefüllte Leitklebeverbindung, die teil- und/oder vollflächig im Bereich der Lötspitzen 46 auf die offenen Enden der Kontaktdrähte 12 aufgebracht wird. Wie Figur 4 zeigt, sind die Löcher 22 der Leiterplatte 16 mit einer Verkupferung 36 versehen. Die Verkupferung erstreckt sich im Wesentlichen in vertikaler Richtung entlang der Löcher bzw. der Bohrungen 22 sowie über Teilbereiche der Oberseite 18 und der Unterseite 20 der Leiterplatte 16. Beim Selektivlötprozess bzw. beim Verlöten mit der in Figur 2 dargestellten Lotwelle 28 stellt sich - wie in Figur 4 dargestellt - eine elektrische Kontaktierung des mit der leitfähigen Polymerschicht 42 versehenen Drahtes 12 und der Verkupferung 36 der entsprechenden Öffnung 22 bzw. des entsprechenden Loches 22 der Leiterplatte 16 ein. Die elektrische Kontaktierung zwischen der leitfähigen Polymerschicht 42 und der Verkupferung 36 wird durch das Lot 38 gebildet. Oftmals kann auf den elektrischen Anschlüssen der Leiterplatte 16 (Kupfer) noch eine Schutzschicht aufgebracht sein. Bei dieser handelt es sich um eine Metallisierung, wozu üblicherweise Sn, NiSn oder NiAu eingesetzt wird; es besteht jedoch auch die Möglichkeit, eine organische Schutzschicht aufzubringen.

Mit Position 44 ist die Schichtdicke des leitfähigen Polymers 42, bei dem es sich beispielsweise um eine hochgefüllte Leitklebeverbindung handeln kann, angedeutet. Die Schichtdicke 44 der leitfähigen Polymerschicht 42 liegt im Bereich zwischen 1 µm bis 200 µm.

Bei einer thermisch induzierten Belastung auf den Anschlussdraht 12 bzw. die Lötspitze 46, die in Form einer Biegebeanspruchung, einer Rotationsbeanspruchung sowie einer Zugbeanspruchung auftreten kann, wird ein Teil der mechanisch schädigenden Belastung durch die als Dämpfer dienende leitfähige Polymerschicht 42 abgefedert. Dies bedeutet, dass die elektrische Verbindung - gebildet durch das Lot 38 - zwischen dem Anschlussdraht 12 und der Verkupferung 36 nicht unmittelbar sämtlichen erwähnten mechanischen Belastungen ausgesetzt ist, sondern dass diese durch die leitfähige Polymerschicht 42 gedämpft werden, so dass eine längere schadensfreie Standzeit einer derart hergestellten elektrischen Verbindung vorliegt. Insgesamt gesehen kann eine höhere Lebensdauer einer erfindungsgemäß hergestellten bzw. erzeugten elektrischen Verbindung erwartet werden.

In einer vorteilhaften Weiterbildung des erfindungsgemäß vorgeschlagenen Verfahrens kann die elektrische Kontaktierung nicht unmittelbar auf einen Polymer-Metallverbund aufgebracht werden, sondern auf diese wird eine Kontaktschicht aufgebracht, die ein nachfolgendes Löten ermöglicht. Es besteht die Möglichkeit, zwischen dem Material des Kontaktdrahtes und dem Polymer-Metallverbund weitere Zwischenschichten aufzubringen, die als Haftvermittler wirken. Unter Polymer-Metallverbund ist ein Verbund aus dem unbehandelten Material des Kontaktdrahtes 12 bzw. dessen Mantelfläche und der leitfähigen Polymerschicht 42 zu verstehen. Um die Eigenschaften der elektrischen Kontaktierung zu verbessern, wird statt auf den vorstehend erwähnten Polymer-Metallverbund zu löten zuvor auf die Kontaktdrähte 12 eine NiSn-Doppelschicht abgeschieden. Bei der Abscheidung der Nickelschicht ist dafür Sorge zu tragen, dass die abgeschiedene Nickelschicht am beschichteten Pin angebunden ist um eine spätere Delamination zu vermeiden. Dazu wird zunächst die Oberfläche des Polymer-Metallverbundes mit Nickel beschichtet, bevor in einem nachfolgenden Verfahrensschritt eine Zinnmetallisierung aufgebracht wird. Bei der Zinnmetallisierung kann es sich beispielsweise um eine matte Zinnmetallisierung handeln.

Auf die Mantelfläche des Kontaktdrahtes 12 kann zunächst Nickel abgeschieden werden. Auf der abgeschiedenen Nickelschicht wird Zinn als Oxidationsschutz in einem weiteren, zweiten Prozessschritt aufgebracht. Grundsätzlich besteht die Möglichkeit, jede lötfähige Schicht bzw. Doppelschicht auch direkt auf den Polymer-Metallverbund aufzutragen. Gemäß einer heute üblichen Praxis wird auf die kupferbasierten Kontaktdrähte 12 eine Zinnschicht abgeschieden und auf eisenbasierten Pins eine Ni-Sn-Schicht abgeschieden. Es besteht jedoch auch die Möglichkeit, NiPdAu und ähnliche Materialien aufzubringen, wobei das favorisierte Basismaterial Nickel ist.

In einer möglichen Ausführungsvariante des erfindungsgemäß vorgeschlagenen Verfahrens kann eine komplette Ummantelung der Kontaktdrähte 12 bzw. der Lötspitzen 46 mit einer leitfähigen Polymerschicht durch Eintauchen realisiert werden. In diesem Falle würden die Lötspitzen 46 der Kontaktdrähte 12 von einem kompletten Verbund aus leitfähigem Polymermaterial 42 umschlossen sein. In dieser Ausführungsvariante stellt sich ein zu erwartender Grenzstrom ein, der einem Grenzstrom eines typischen Leitklebers entspricht. Es besteht jedoch auch die Möglichkeit eine Teilbeschichtung, sei es eine einseitige oder eine zweiseitige, von den Kontaktdrähten 12 durch Pastendruck vorzunehmen. In diesem Fall stellt sich ein Grenzstrom ein, in Bezug auf die teilbeschichtete Variante, der identisch ist mit einem Grenzstrom einer unbeschichteten Referenz.

Die erfindungsgemäß vorgeschlagene leitfähige Polymerschicht 42 kann beispielsweise durch einen Leitklebstoff, wie zum Beispiel dem Produkt Namics H9117s durchgeführt werden. Alternativ dazu lässt sich auch der Leitklebstoff BCE 30374M einsetzen. Die Leitklebstoffe weisen nach dem Aushärten einen E-Modul unterhalb der Glasübergangstemperatur von ca. 8 GPa (oberhalb 200 Mpa) auf, der damit signifikant kleiner ist als der E-Modul des Lotes 38, der zwischen 30 bis 50 GPa liegt. Die elektrische Leitfähigkeit eines derartigen Leitklebers liegt in der Größenordnung von ca. 0,001 Ω/cm.

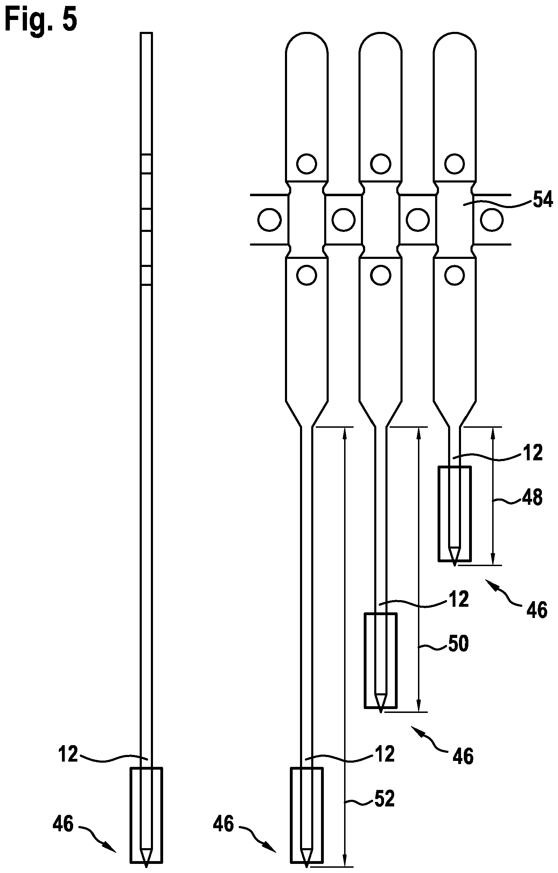

Der Darstellung gemäß Figur 5 ist ein Verbund aus mehreren Kontakten zu entnehmen, dessen Kontaktdrähte jeweils eine unterschiedliche freie Länge aufweisen.

Wie aus Figur 5 hervorgeht, sind in dieser Figur dargestellten Draufsicht die Kontaktdrähte 12 in unterschiedlichen Kontaktdrahtlängen 48, 50 bzw. 52 ausgebildet. An einer jeden Lötspitze 46 der einzelnen Kontaktdrähte 12 sind die leitfähigen Polymerschichten 42 in einer im Wesentlichen einheitlichen Längserstreckung ausgeführt. Aus der in Figur 5 ebenfalls dargestellten Seitenansicht geht hervor, dass die einzelnen Kontaktdrähte 12 hier als rechteckige Flachdrähte ausgebildet sind; alternativ besteht selbstverständlich auch die Möglichkeit, die Kontaktdrähte 12, die sich von der Unterseite der zu kontaktierenden Komponente 10 aus erstrecken, auch in einer anderen Querschnittsgeometrie auszubilden. Dies ist applikationsabhängig, da die durch die Kontaktdrähte 12 zu kontaktierende Leiterplatte 16 mit komplementärem Querschnitt hinsichtlich der Öffnungen bzw. Löcher 22 gefertigt werden muss.

Alternativ zum Eintauchverfahren zur Erzeugung der Beschichtung des Polymer-Metallverbundes, d.h. des Verbundes aus dem Kontaktdraht 12 und der leitfähigen Polymerbeschichtung 42, können auch anderen Techniken eingesetzt werden. Auch ein vollständiges Ummanteln der Kontaktdrähte 12 ist nicht zwingend erforderlich. Es existieren alternative Fertigungsverfahren, um die Beschichtung im Rahmen von Coating-Verfahren zu erzeugen. So kann die leitfähige Polymerbeschichtung 42 beispielsweise durch Sieb- und/oder Schablonendruck der die leitfähige Polymerbeschichtung 42 bildenden Pasten auf die Lötspitzen 46 der Kontaktdrähte 12 aufgebracht werden. In der Regel werden die Kontaktdrähte 12 bzw. Kontaktpins 12 aus Bändern ausgestanzt und haben demzufolge einen rechteckförmigen Querschnitt und sind beispielsweise als flache Kontaktstifte 12 beschaffen. Daneben besteht die Möglichkeit, die leitfähige Polymerbeschichtung 42 im Wege des Inkjet-Verfahrens an den Lötspitzen 46 zu erzeugen. Die leitfähige Polymerbeschichtung 42 kann durch lokales Aufspritzen nur auf den Bereich der Lötspitze 46 der Kontaktdrähte bzw. der Kontaktpins 12 aufgebracht werden. Des Weiteren besteht die Möglichkeit, mit der leitfähigen Polymerbeschichtung 42 imprägniertes Gewebe um die Mantelfläche der Kontaktdrähte 12 bzw. der Kontaktpins 12 herumzuwickeln. Die im Wege des Sieb- und/oder Schablonendruckes oder durch das Inkjet-Verfahren oder durch das letztgenannte Wickelverfahren erzeugten Geometrien können sich über größere Bereiche der Kontaktdrähte 12 bzw. der Kontaktpins 12 erstrecken. Je nach Schablonengröße bzw. Inkjet-Spritzbereich sowie der gewählten Wickelgeometrie können die mit der leitfähigen Polymerbeschichtung 42 versehenen Bereiche der Kontaktdrähte 12 bzw. der Kontaktpins 12 individuell gestaltet werden. Durch das erfindungsgemäß vorgeschlagene Verfahren kann eine elektrische Durchkontaktierung durch das THT-Verfahren erzeugt werden, die sich beispielsweise von der Oberseite 18 der Leiterplatte 16 zur Unterseite 20 der Leiterplatte 16 erstreckt. Zwischen der Oberseite 18 und der Unterseite 20 der Leiterplatte 16 können bei einem geschichtet ausgebildeten Leiteraufbau der Leiterplatte 16 Stromabzweigungen verlaufen; ebenso können die elektrischen Durchkontaktierungen, die mit dem erfindungsgemäß vorgeschlagenen Verfahren erzeugt werden als blind vias oder als buried vias ausgebildet sein.

## Patentansprüche

1. Verfahren zur Herstellung einer elektrischen Durchkontaktierung zwischen einem oder mehreren elektrischen oder elektronischen Bauelementen (10) und einer Leiterplatte (16) mit nachfolgenden Verfahrensschritten:
a) Erzeugen eines Polymer-Metallverbunds durch teil- oder vollflächiges Aufbringen einer leitfähigen Polymerschicht (42) auf Lötspitzen (46) von Anschlussdrähten (12) eines zu kontaktierenden elektrischen oder elektronischen Bauelementes (10),
b) Fügen des mindestens einen elektrischen oder elektronischen Bauelementes (10) und der Leiterplatte (16) mit dem THT-Verfahren und
c) Erzeugen mindestens einer Lötverbindung zwischen der Leiterplatte (16) und der leitfähigen Polymerschicht (42) des mindestens einen elektrischen oder elektronischen Bauelementes (10) durch Selektivlötung oder eine Lotwelle (28).

2. Verfahren gemäß Anspruch 1, **dadurch gekennzeichnet, dass** als leitfähige Polymerschicht (42) eine hochgefüllte Leitkleberverbindung aufgebracht wird.

3. Verfahren gemäß Anspruch 1, **dadurch gekennzeichnet, dass** gemäß Verfahrensschritt a) die leitfähige Polymerschicht (42) in Verkupferungen (36) von Löchern oder Öffnungen (22) der Leiterplatte (16) eingelötet wird.

4. Verfahren gemäß Anspruch 1, **dadurch gekennzeichnet, dass** nach Durchführung des Verfahrensschrittes a) und vor Durchführung des Verfahrensschrittes b) auf den Polymer-Metallverbund eine NiSn-Doppelschicht mit einer Nickelschicht und einer Zinnschicht ausgebildet wird.

5. Verfahren gemäß dem vorhergehenden Anspruch, **dadurch gekennzeichnet, dass** die Nickelschicht an dem Polymer-Metallverbund derart angebunden wird, dass eine Delamination vermieden wird.

6. Verfahren gemäß den beiden vorhergehenden Ansprüchen, **dadurch gekennzeichnet, dass** zunächst eine Nickelschicht auf den Polymer-Metallverbund abgeschieden und anschließend eine Zinnmetallisierung, insbesondere eine Mattzinnmetallisierung aufgebracht wird.

7. Verfahren gemäß einem der vorhergehenden Ansprüche, **dadurch gekennzeichnet, dass** eine zumindest teilweise Beschichtung der Lötspitzen (46) der Kontaktdrähte (12) durch Eintauchen oder andere Coating-Verfahren erzeugt wird.

8. Verfahren gemäß einem der vorhergehenden Ansprüche, **dadurch gekennzeichnet, dass** eine Teilbeschichtung des Kontaktdrahtes mit einem leitfähigem Polymer erfolgt und/oder metallgefülltes Harz auf die Kontaktdrähte (12) im Schablonen- oder Siebdruckverfahren aufgebracht wird.

9. Verfahren gemäß einem der vorhergehenden Ansprüche, **dadurch gekennzeichnet, dass** bei einer Beschichtung der Lötspitzen (46) ein Leitklebstoff verwendet wird, der nach dem Aushärten einen E-Modul von oberhalb 200 MPa aufweist und eine elektrische Leitfähigkeit von ca. 0,001 Ω/cm aufweist.

10. Verfahren gemäß einem der vorhergehenden Ansprüche, **dadurch gekennzeichnet, dass** die thermischen Ausdehnungskoeffizienten des Kontaktdrahtes (12), insbesondere der Lötspitzen (46) und die der leitfähigen Polymerschicht (42) im Wesentlichen einander entsprechen.

## Claims

1. Method for producing an electrical via between one or more electrical or electronic components (10) and a circuit board (16) comprising the following method steps:
a) producing a polymer-metal composite by applying a conductive polymer layer (42) to soldering tips (46) of connecting wires (12), over part of the surface or over the full surface thereof, of an electrical or electronic component (10) to be contacted,
b) joining the at least one electrical or electronic component (10) and the circuit board (16) by the THT process and
c) producing at least one soldered connection between the circuit board (16) and the conductive polymer layer (42) of the at least one electrical or electronic component (10) by selective soldering or a solder wave (28).

2. Method according to Claim 1, **characterized in that** a highly filled conductive adhesive compound is applied as the conductive polymer layer (42).

3. Method according to Claim 1, **characterized in that**, according to method step a), the conductive polymer layer (42) is soldered into copper platings (36) of holes or openings (22) in the circuit board (16).

4. Method according to Claim 1, **characterized in that**, after carrying out method step a) and before carrying out method step b), a double NiSn layer comprising a nickel layer and a tin layer is formed on the polymer-metal composite.

5. Method according to the preceding claims, **characterized in that** the nickel layer is bonded onto the polymer-metal composite in such a way that delamination is avoided.

6. Method according to one of the two preceding claims, **characterized in that** first a nickel layer is deposited onto the polymer-metal composite and then a tin metallization, in particular a matt tin metallization, is applied.

7. Method according to one of the preceding claims, **characterized in that** an at least partial coating of the soldering tips (46) of the contact wires (12) is produced by dipping or other coating processes.

8. Method according to one of the preceding claims, **characterized in that** a partial coating of the contact wire with a conductive polymer is performed and/or metal-filled resin is applied to the contact wires (12) by the stencil or screen printing process.

9. Method according to one of the preceding claims, **characterized in that** a conductive adhesive that has after curing a modulus of elasticity of above 200 MPa and an electrical conductivity of about 0.001 Ω/cm is used when coating the soldering tips (46).

10. Method according to one of the preceding claims, **characterized in that** the coefficients of thermal expansion of the contact wire (12), in particular of the soldering tips (46) and that of the conductive polymer layer (42) correspond substantially to one another.

## Revendications

1. Procédé destiné à la production d'un via électrique entre un ou plusieurs composants électriques ou électroniques (10) et une carte de circuit imprimé (16) avec les phases de procédé suivantes :
a) la production d'un matériau composite en métal et en polymère par application, sur une surface partielle ou sur la totalité de la surface, d'une couche de polymère (42) conductrice sur des pannes à souder (46) de fils de connexion (12) d'un composant (10) électrique ou électronique devant être mis en contact ;
b) l'assemblage de l'au moins un composant (10) électrique ou électronique et de la carte de circuit imprimé (16) selon le procédé THT ; et
c) la production d'au moins une liaison par brasage entre la carte de circuit imprimé (16) et la couche de polymère (42) conductrice de l'au moins un composant (10) électrique ou électronique, par l'intermédiaire d'un brasage sélectif ou d'une vague de brasage (28).

2. Procédé selon la revendication 1, **caractérisé en ce qu'**une liaison par agent adhésif conducteur à forte charge est appliquée sous la forme d'une couche de polymère (42) conductrice.

3. Procédé selon la revendication 1, **caractérisé en ce que**, conformément à la phase de procédé a), la couche de polymère (42) conductrice est brasée en cuivrages (36) des trous ou des orifices (22) de la carte de circuit imprimé (16).

4. Procédé selon la revendication 1, **caractérisé en ce que**, à l'issue de la réalisation de la phase de procédé a) et avant la réalisation de la phase de procédé b), une double couche de NiSn est formée sur le matériau composite en métal et en polymère, avec une couche de nickel et une couche d'étain.

5. Procédé selon la revendication précédente, **caractérisé en ce que** la couche de nickel est fixée de telle sorte au matériau composite en métal et en polymère que toute délamination est évitée.

6. Procédé selon les deux revendications précédentes, **caractérisé en ce qu'**une couche de nickel est d'abord déposée sur le matériau composite en métal et en polymère, puis une métallisation à l'étain est ensuite appliquée, en particulier une métallisation à l'étain mat.

7. Procédé selon l'une des revendications précédentes, **caractérisé en ce que**, tout au moins en partie, un revêtement des pannes à souder (46) des fils de mise en contact (12) est réalisé selon un procédé par immersion ou selon un autre procédé de revêtement.

8. Procédé selon l'une des revendications précédentes, **caractérisé en ce qu'**un revêtement partiel du fil de mise en contact est réalisé au moyen d'un polymère conducteur et/ou une résine chargée de métal est appliquée sur les fils de mise en contact (12) selon un procédé de gabarit ou de sérigraphie.

9. Procédé selon l'une des revendications précédentes, **caractérisé en ce qu'**un agent adhésif conducteur est utilisé dans le cas d'un revêtement des pannes à souder (46), lequel agent adhésif conducteur présente un module E d'élasticité supérieur à 200 MPa à l'issue de son durcissement et lequel présente une conductivité électrique d'environ 0,001 Ω/cm.

10. Procédé selon l'une des revendications précédentes, **caractérisé en ce que** les coefficients de dilatation thermique du fil de mise en contact (12), en particulier des pannes à souder (46), et ceux de la couche de polymère (42) conductrice correspondent, pour l'essentiel, les uns aux autres.
